(19) Europäisches Patentamt
European Patent Office
Office européen des brevets

(11) **EP 3 683 850 A1**

(12) **EUROPÄISCHE PATENTANMELDUNG**

(43) Veröffentlichungstag:
**22.07.2020  Patentblatt 2020/30**

(51) Int Cl.:
*H01L 35/22* *(2006.01)*      *H01L 35/34* *(2006.01)*

(21) Anmeldenummer: **19152254.9**

(22) Anmeldetag: **17.01.2019**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(71) Anmelder: **Evonik Degussa GmbH**
**45128 Essen (DE)**

(72) Erfinder:
• **LANG, Dr., Jürgen Erwin**
**76229 Karlsruhe (DE)**

• **SUHR, Silke**
**63776 Mömbris (DE)**
• **STENNER, Patrik**
**6342 Hanau (DE)**

(74) Vertreter: **Evonik Patent Association**
**c/o Evonik Industries AG**
**IP Management**
**Bau 1042A/PB 15**
**Paul-Baumann-Straße 1**
**45772 Marl (DE)**

(54) **THERMOELEKTRISCHE UMWANDLUNGSELEMENTE UND DEREN HERSTELLUNG MITTELS BEHANDLUNG VON SILIZIUMLEGIERUNGSPULVER**

(57)    Gegenstand der Erfindung ist ein thermoelektrisches Umwandlungselement TE, welches dadurch gekennzeichnet ist, dass das Element zumindest zwei poröse Schichten aufweist, von denen zumindest eine Schicht n- und zumindest eine andere Schicht p- dotiertes Material enthält oder ist, wobei das Material der porösen Schichten heißgesintert ist, sowie das Verfahren zu dessen Herstellung, sowie die Verwendung des TE.

EP 3 683 850 A1

## Beschreibung

Die vorliegende Erfindung bezieht sich auf ein thermoelektrisches Umwandlungselement, das sich breitbandig für Einsatztemperaturen von kryogenen Temperaturen ab -273°C über Raumtemperatur bis hin zu höchsten Temperaturen bei etwa 1000 °C eignet, wie sie beispielsweise in Brennräumen vorliegen. Solche Umwandlungselemente finden neben sensorischen Anwendungen vorzugsweise Verwendung, um (Ab-)Wärme zu nutzen und diesen Wärmefluss direkt in elektrischen Strom umzuwandeln.

Hierzu werden thermoelektrische Materialien, die aus Siliziumlegierungen bestehen, für Umwandlungselemente bereitgestellt, die von -273°C bis zu höchsten Betriebstemperaturen von 900°C oder höher verwendbar sind. Das Umwandlungselement weist eine Schichtstruktur sowie Elektroden auf. Die Schichtstruktur enthält eine Anzahl Ap/2 an Siliziumpulversubstraten vom p-Legierungstyp und eine Anzahl An/2 = Ap/2 vom Siliziumpulversubstraten vom n- Legierungstyp, die alternierend aufeinander geschichtet werden. Die Siliziumpulversubstrate bestehen aus Siliziumlegierungspartikeln. Diese Siliziumlegierungspartikel können durch Mischung von Silan mit einem Legierungsmetall wie Bor und deren Gasphasen-Pyrolyse hergestellt werden. Die Pulver haben eine Partikelgrößenverteilung mit einer vorzugsweisen mittleren Partikelgröße von 10 nm bis 1000 nm. Die Pulver werden in eine Zielform geschüttet und auf eine Dichte vorzugsweise von 10 bis 99 % der theoretischen Festkörperdichte gesintert. Über die Partikelgröße sowie die Sinterdichte der Substrate wird die gewünschte Wärmeleitfähigkeit eingestellt. Die Substrate vom p-Typ und n-Typ haben nach der erfindungsgemäßen Prozessierung vorzugsweise Dicken von 0,1 mm bis 3,0 cm.

## Stand der Technik

Auf dem Gebiet der Energieumwandlungstechnik sind thermoelektrische Generatoren bekannt. Eine Verwendung basiert auf der Nutzung der Energie, die zu etwa 70 % in Form von Abgaswärme bei einem Verbrennungsmotor emittiert wird. Die Anwendung eines thermoelektrischen Materials ist daher von dem Gesichtspunkt der Verbesserung der Treibstoffverbrauchsrate untersucht worden.

Automobilabgase erreichen typischerweise Temperaturen von 600 °C - 1000 °C oder mehr am Auslassventil. Soll ein thermoelektrisches Umwandlungsmodul betrieben werden, muss dieses bei derart hohen Temperaturen einsatzfähig sein.

Dem Stand der Technik werden immer wieder thermoelektrische Materialien mit hohen thermoelektrischen Kennzahlen ZT abverlangt. Die Kennzahl ZT ist die fachübliche Funktion des Seebeck-Koeffizienten a, der Einsatz-Temperatur T, der spezifischen elektrischen Leitfähigkeit $\sigma$ sowie der spezifischen Wärmeleitfähigkeit Y:

$$ZT = \frac{\alpha^2\,\mathsf{T}\,\sigma}{\mathsf{Y}}$$

In den üblicherweise verwendeten Ausdruck für den thermoelektrischen Wirkungsgrad $\eta$ geht ZT ein wie folgt:

$$\eta = \frac{\sqrt{1+ZT}-1}{\sqrt{1+ZT}+\mathsf{Tu/T}}\ \frac{\mathsf{T}-\mathsf{Tu}}{\mathsf{T}},$$

wobei Tu die Umgebungstemperatur ist. Der Begriff *"spezifische Wärmeleitfähigkeit"* wird im Rahmen der Erfindung mit *"Wärmeleitfähigkeit"* abgekürzt.

Halbleitermaterial der Bi-Te-Serie (Wismut-Tellurid) ist bislang das industriell bevorzugte thermoelektrische Material. Aufgrund seiner physikalischen Eigenschaften kann es bei höheren Temperaturen als etwa 300 °C nicht eingesetzt werden, da das Halbleitermaterial verdampft und dadurch die thermoelektrische Kennzahl ZT erheblich verschlechtert. Ferner sind Bi-Te sowie andere thermoelektrische Materialien wie Silizide, Oxide, oder thermoelektrische Materialien von Halb-Häusler-Typ zwar für eine Verwendung bei hohen Temperaturen dem Grund nach geeignet. Doch sind diese entweder industriell nicht in größeren Mengen verfügbar oder nicht preiswert herstellbar. Zum Beispiel sind Silizide wasserempfindlich und bergen ein nicht vernachlässigbares Brand-Risiko.

In *"Showa-Densen-Review"*, Vol. 58, No. 1, 2008, wird ein thermoelektrisches Umwandlungsmaterial aus Silizid oder Oxidserien beschrieben, das über ein metallurgischen Prozess hergestellt wird. Diese Materialien werden im Zuge der Prozessierung in viele Blöcke geteilt, um thermoelektrische Elemente herzustellen. Solch ein Prozess ist teuer und für eine Massenproduktion nicht geeignet.

Thermoelektrische Umwandlungselemente erfordern ein an den Einsatzzweck angepasste Wärmeleitfähigkeit zwischen seiner Hoch- und Niedertemperaturseite. Dabei ist nicht nur die Temperaturdifferenz zwischen den Hoch- und Niedertemperaturseite eine relevante Designgröße, sondern auch der gewünschte Wärmefluss über das Thermoelement. Als die Erfinder untersuchten, wie das thermoelektrische Element beispielsweise bei einer hohen Temperatur bei 500 °C oder höher zu betreiben ist, wie dies bei einer Verwendung im Abgasstrang eines Benzin-/Dieselmotors zu erwarten ist, wurde festgestellt, dass sowohl die Verlässlichkeit der Isolation als auch die Wärmeleiteigenschaften großen Einfluss auf die thermoelektrische Umwandlungseffizienz haben.

## Erfindung

Eine Aufgabe der vorliegenden Erfindung ist es daher, ein thermoelektrisch aktives Material mit einer hohen thermoelektrischen Kennzahl ZT bereit zu stellen, das preiswert im großtechnischen Maßstab hergestellt werden kann. Das Material ist in der Form bereitzustellen, dass es sich eignet, in einem weiteren Schritt so prozessierbar zu sein, dass seine Wärmeleitfähigkeit und darüber der Wärmefluss an die Einsatzgeometrie des thermoelektrischen Umwandlungselements angepasst werden kann. Die Geometrie richtet sich an dem Beispielfall einer Energiegewinnung aus Abwärme aus und sollte bei hohen Temperaturen etwa bei 450 °C oder höher, beispielsweise bei 500 °C oder höheren Temperaturen, einsetzbar sein.

Der Begriff "thermoelektrisches Umwandlungselement" ist im Rahmen der Erfindung mit "TE" abgekürzt.

Die vorliegende Erfindung stellt ein auf seinen Einsatzfall optimiertes thermoelektrisches Umwandlungselement bereit, das an gewünschte Betriebsbedingungen angepasst ist. Diese kann 450 °C, vorzugsweise 500 °C oder höher sein. In der dem Fachmann bekannten Weise kommt es auf das jeweilige Energieangebot und seine spezifische Energiedichte (W cm$^{-3}$) im Einsatzfall an, auf den der/ein gewünschter Wärmefluss des thermoelektrischen Elements auszulegen ist.

Gegenstand der Erfindung ist ein thermoelektrisches Umwandlungselement, das dadurch gekennzeichnet ist, dass das Element zumindest zwei poröse Schichten aufweist, von denen zumindest eine Schicht n- und zumindest eine andere Schicht p- dotiertes Material enthält oder ist. Das Material der porösen Schichten ist heißgesintert.

Vorzugsweise ist das Material der porösen Schichten n- bzw. p-dotiert, vorzugsweise zumindest eines dieser Materialien dotiertes Silizium. Die Materialien für die n- bzw. p-Dotierung sind fachüblich ausgewählt.

Mit Bezug auf die Erzeugung einer Spannung aufgrund einer Temperatur-Differenz können die p- und n-Elemente bevorzugt dasselbe Basismaterial, nämlich Silizium, aufweisen.

Das erfindungsgemäße TE hat den Vorteil, dass es an die Temperatur des Wärme transportierenden Mediums, das gasförmig und/oder flüssig sein kann und im Rahmen der Erfindung mit "Wärmestrom" bezeichnet ist, sowie an die Temperatur des Kühlmediums angepasst sein kann, weil über seine Porosität dessen Dichte und Wärmeleitfähigkeit eingestellt werden können. Vorzugsweise liefert das erfindungsgemäße TE elektrische Energie bei Temperaturen Wärmestromes, bereits bei 20 °C oder höher. Bevorzugt arbeitet das TE bei einer Temperatur von mindestens 50 °C, bei Temperaturen also, die in haushaltsüblichen Heizanlagen vorkommen, weiterhin bevorzugt bei mindestens 300 °C, besonders bevorzugt bei mindestens 450 °C oder mindestens 500 °C. Temperaturen in den Bereichen um 300 °C, 450 °C oder 500 °C oder höher treten in Wärmeströmen von Abgasen auf, beispielsweise im Abgasstrang eines typischen Verbrennungsmotors.

Überraschend wurde gefunden, dass das erfindungsgemäße siliziumlegierte thermoelektrische Umwandlungselement bei Einsatztemperaturen von 500 °C bis 700 °C, vorzugsweise bei etwa 600 °C, die zum Beispiel im Abgasstrang eines Automobils herrschen, einen thermoelektrischen Gütefaktor ZT von 1 innerhalb fachüblicher Meßfehlergrenzen aufweist, wobei ein Seebeck-Koeffizient von 100 bis 200 $\mu$V K$^{-1}$ vorliegt, vorzugsweise von etwa 150 $\mu$V K$^{-1}$.

Weiterhin besonders bevorzugt liefert das erfindungsgemäße TE bei Temperaturen bis zu 1200 °C, die bei Wärmeströmen in metallurgischen Prozessen auftreten, elektrische Energie.

Somit ist gleichfalls Gegenstand der Erfindung die Verwendung des erfindungsgemäßen TE bei Temperaturen bis zu 1200 °C.

Vorzugsweise kann das erfindungsgemäße TE bei metallurgischen Prozessen, in Abgasströmen bei Verbrennungsprozessen oder in Heizanlagen verwendet werden.

Das erfindungsgemäße TE kann neben einer Schichtstruktur auch Elektroden aufweisen, die in einer Vielzahl vom p-Typ und eine Vielzahl vom n-Typ Elementen vorliegen, die alternierend aufeinander geschichtet sind.

Die Zwischenräume benachbarter thermoelektrischer Elemente können mit einem Isolationsmaterial ausgefüllt sein. Das Isolationssystem weist ein anorganisches Partikelsystem auf und kann mit einem dem Fachmann bekannten Trübungsmittel funktionalisiert sein. Beispielsweise kann eine Mischung aus nanoskaliger Kieselsäure, Kohlenstoff- oder SiC-Partikel mit einem anorganischen Binder verfestigt sein.

Ein weiterer Gegenstand der Erfindung ist ein Verfahren zum Herstellen eines thermoelektrischen Umwandlungselements, aufweisend die Schritte

   1) Bereitstellen von p-Typ und n-Typ Pulver-Substraten,

2) Aufschichten der p-Typ und n-Typ Pulver-Substrate, wobei eine Schichtung erhalten wird,

3) Verdichten der Schichtung mittels Pressen und Heißsintern auf eine Dichte, wobei das thermoelektrische Umwandlungselement erhalten wird.

Die im Schritt 3 erreichte Dichte und die Wärmeleitfähigkeit des TE hängen in eindeutiger Weise zusammen, wie der Fachmann durch bekannte Messverfahren leicht ermitteln kann.

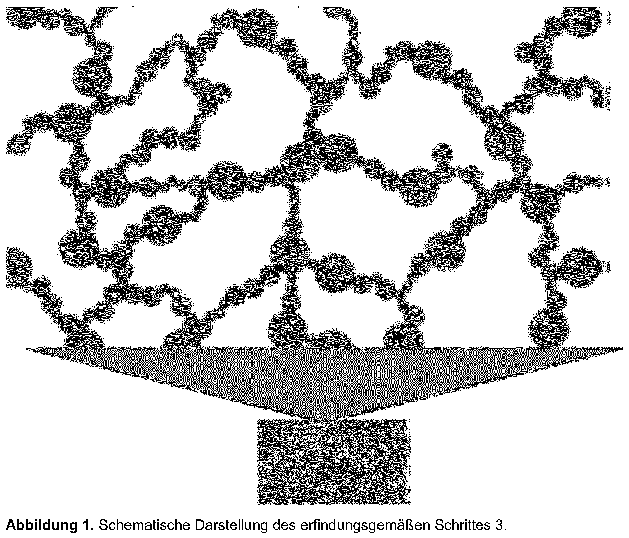

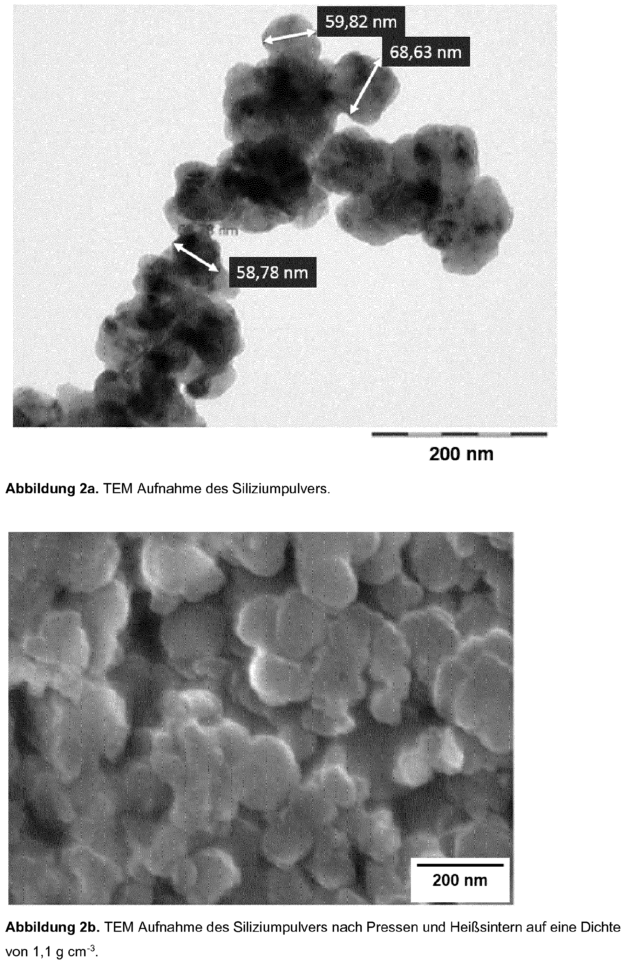

Den Vorgang des Pressens und Heißsinterns gemäß Schritt 3 zeit **Abbildung 1** schematisch. Die Primärpartikel, wobei der Begriff im Rahmen der Erfindung zum Begriff "Partikel" abgekürzt ist, werden erfindungsgemäß gepresst und heißgesintert und somit verdichtet. Wird beispielsweise Siliziumpulver erfindungsgemäß eingesetzt, ermöglicht der erfindungsgemäße Schritt 3 eine Erhöhung der Dichte von etwa 0,1 g cm$^{-3}$ auf bis zu 2,2 g cm$^{-3}$, also nahezu auf die Dichte des Festkörpers. In dem weiter unten geschilderten Beispiel ist dies der Übergang vom Zustand des Siliziumpulvers in der **Abbildung 2a** zu der verdichteten Masse in der **Abbildung 2b.**

Die im Schritt 3 erhaltene verdichtete Schichtung weist eine Wärmeleitfähigkeit auf, die anhand ihrer Dichte einstellbar ist. Diese Wärmeleitfähigkeit kann damit an die beim Einsatz des erfindungsgemäßen Umwandlungselementes anliegende Temperaturdifferenz sowie an das beim Einsatz des Elementes erwartete Energieangebot angepasst sein.

Mit der Durchführung des erfindungsgemäßen Schrittes 3 ist der elektrische Widerstand des erfindungsgemäß erhaltenen TE beeinflußbar. Der elektrische Widerstand wird außerdem durch die Länge und den Durchmesser der Kontaktzone zwischen den einzelnen Partikelaggregaten bestimmt. Auch hängt der elektrische Widerstand von der Zahl der Kontaktstellen je Partikelaggregat sowie die Zahl der Partikelaggregate je Raumvolumen ab.

Bei einer Temperaturdifferenz von ungefähr 500 °K generiert das erfindungsgemäße Umwandlungselement eine Spannung von 50 bis 100 mV zwischen beiden Enden des thermoelektrischen Materials. Falls die p- und n- thermoelektrischen Materialien in Reihe verbunden sind, erhöht jedes verwendete Thermopaar die Thermospannung zwischen den beiden äußersten Enden des erfindungsgemäßen Umwandlungselementes die Potenzialdifferenz um etwa 100 mV.

Da die obere Grenze der Betriebstemperatur von den Materialien des erfindungsgemäßen Umwandlungselementes und seiner Wärmeleitfähigkeit und dem spezifischen Energiedargebot abhängt, kann das Umwandlungselement an die Betriebstemperatur angepasst werden.

Somit stellt die vorliegende Erfindung ein TE für eine Verwendung vorzugsweise mit einer Betriebstemperatur von 20°C oder höher bereit. Die Betriebstemperatur kann bevorzugt 50°C, der typischen Vorlauftemperatur einer Heizung im Wohnbereich, 300°C etwa bei Abgasen, oder höher sein.

Weiterhin bevorzugt kann die Betriebstemperatur auf solche Temperaturen eingestellt werden, die bei Anwendungen im Bereich der Nutzung der Abwärme bei metallurgischen Prozessen auftreten, z.B. auf 1200 °C oder niedriger.

Das Siliziumpulver in dem Schritt 1 des erfindungsgemäßen Verfahrens weist eine mittlere Partikelgröße und Partikelgrößenverteilung auf. Dieses Pulver kann durch Pyrolyse eines Monosilan-, Boran bzw. Monosilan-Phosphin - Gemisches unter Beisein eines Kohlenwasserstoffs, z.B. von Methan hergestellt werden. Das über den Pyrolyseprozess erhaltene Pulver ist in der fachüblichen Weise in eine negative Form einzubringen, z.B. durch Einstreuen und anschließend Heißpresssintern zu unterziehen, wobei ein gesinterter p-n-Siliziumkörper, gleichbedeutend ein erfindungsgemäßes Umwandlungselement erhalten wird. Der so gewonnene plattenförmige Körper kann geschnitten werden, um einzelne Umwandlungselemente zu erhalten.

Alternativ zu einem beispielsweise phosphorhaltigen Precursor können auch andere dem Fachmann bekannte Precursoren basierend auf den Metallen der 3. und 5. Hauptgruppe verwendet werden. Eine bevorzugte Variante für die Herstellung einer n-Typ-Legierung ist z.B. ein antimonhaltiger Precursor.

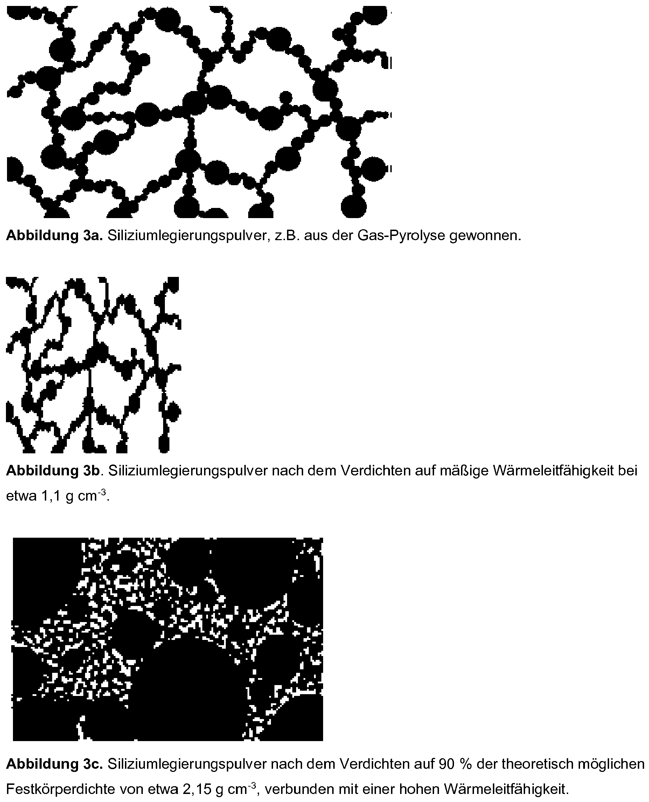

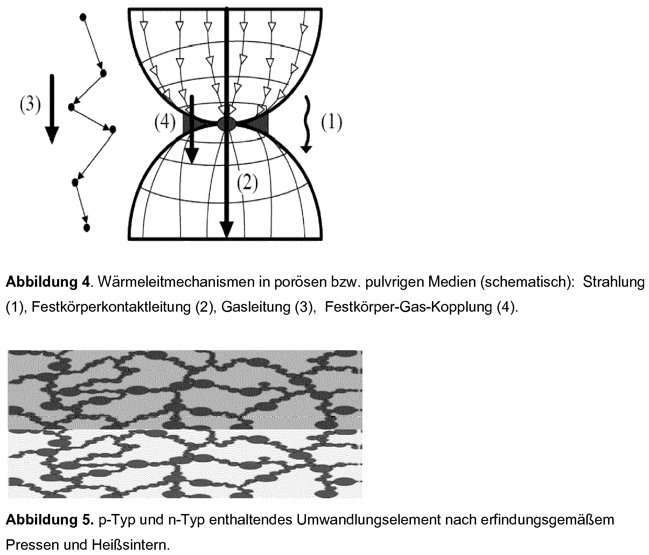

Die nach Schritt 2 des erfindungsgemäßen Verfahrens erhaltene Schichtung wird im Schritt 3 verdichtet. Es ist den nachfolgenden schematischen **Abbildungen 3a** - **3c** und **Abbildung 4** zu entnehmen, dass der Wärmeleitmechanismus wesentlich wird, wenn die Zahl der Festkörperkontakte zunimmt, was durch eine Verdichtung erfolgt. Dies kann einfach durch Anwendung des dem Fachmann bekannten Kugelhaufenmodells verstanden und berechnet werden.

Die **Abbildungen 3a** - **3c** veranschaulichen schematisch die Abhängigkeit der messbaren Schüttdichte des Siliziumpulvers von der Primärpartikelgröße sowie der Partikelgrößenverteilung. In **Abbildung 3a** ist eine Partikelgrößenverteilung im Bereich 40 nm bis 300 nm dargestellt. Dies entspricht einer Schüttdichte des Pulvers in einem Bereich von etwa 0,1 bis 0,15 g cm$^{-3}$ und somit etwa 40 % der Dichte des im verfahrensgemäßen Schritt 3 mäßig verdichteten Materials gemäß **Abbildung 3b.** Bei einer solchen Verdichtung wird ein erfindungsgemäßes Umwandlungselement mit einer mäßigen Wärmeleitfähigkeit erhalten.

In **Abbildung 3c** ist die Partikelgrößenverteilung zwischen 40 nm und 10000 nm schematisch dargestellt, erhalten nach Schritt 3 bei einer hohen Verdichtung.

Das Ausmaß der Verdichtung anhand des Heißsinterns im Schritt 3 stellt die Wärmeleitfähigkeit des erfindungsgemäßen Umwandlungselementes ein, wobei die unterschiedlichen Mechanismen der Wärmeleitung eine von der erreichten Dichte abhängige Gewichtung erleiden. Die **Abbildung 4** stellt Wärmeleitmechanismen schematisch anhand von zwei annähernd kugelförmigen Partikeln dar, die in dem Pulver bzw. in dem Schritt 3 gemäß verdichtetem Pulver Kontakt haben. Die Kontaktstelle ist in der Mitte der **Abbildung 4** gezeigt. Im Allgemeinen bleibt die nanokristalline Struktur der Partikel während der Durchführung des erfindungsgemäßen Verfahrens erhalten. Die Mechanismen der Wärmeleitung, nämlich Strahlung (1), Festkörperkontaktleitung (2), Gasleitung (3), Festkörper-Gas-Kopplung (4), gehen nichtlinear in die Wärmeleitfähigkeit ein.

Die p-Typ und die n-Typ Pulver-Substrate können aufeinander alternierend bereitgestellt werden, schematisch in **Abbildung 5** gezeigt, um ein Super-thermoelektrisches Umwandlungselement zu bilden. Vorzugsweise ist die Gesamtdicke des erfindungsgemäßen sowohl den p-Typ als auch den n-Typ enthaltenden Super-Umwandlungselementes nach dem Heißpressen bzw. Heißsintern größer als 0,1, vorzugsweise größer 0,5 mm und weiterhin bevorzugt kleiner als 30 mm.

Vorzugsweise können die Partikel des Pulvers mit bis zu 2-Gew.-% der Dotierkomponente legiert sein. Dies hat den Vorteil, dass das Umwandlungselement einen reduzierten internen Widerstand aufweist. Des Weiteren findet man einen verbesserten Ausgabestrom.

Die Wärmleitfähigkeit des erfindungsgemäßen Umwandlungselementes kann vorzugsweise wird über die Dichte auf etwa 1,1g cm$^{-3}$ eingestellt werden. Damit kann bei einer Schichtdicke von jedem der Substrate mit bevorzugt 0,5 mm ein Superelement vom Grad 1, vgl. **Abbildung 5,** mit einer Dicke von 1 mm gefertigt werden. Ferner ist es möglich, ein Einbrechen der abgreifbaren Spannung dadurch entgegen zu wirken, dass die Dicke sowohl von dem p-Typ als auch von dem n-Typ Element der Wärmeströmung angepasst wird. Somit wird eine Leistungsanpassung erzielt. Die Dicke des Substrats bei einer Dichte von 1 g cm$^{-3}$ liegt bevorzugt bei 2 mm oder weniger.

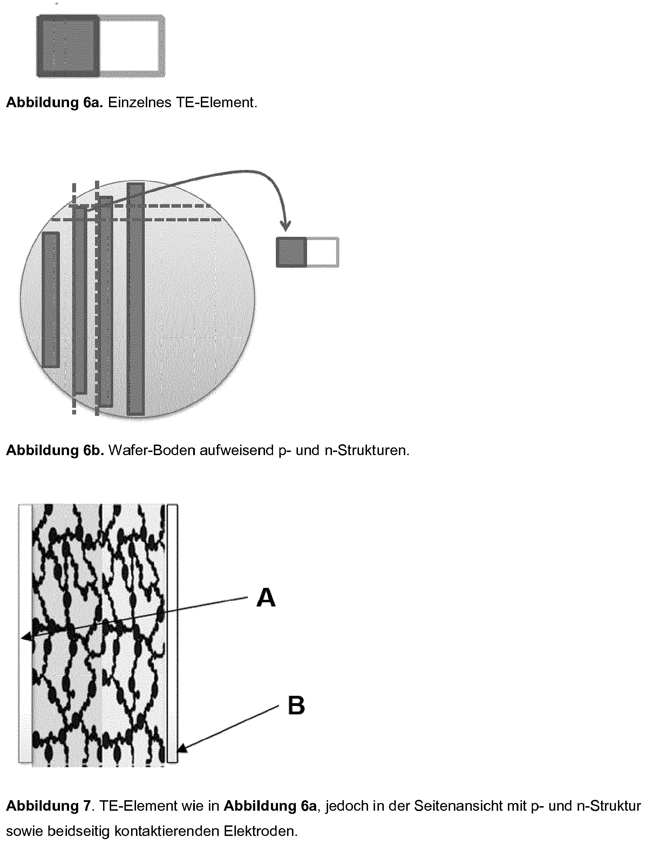

Es kann vorteilhaft sein, mehrere erfindungsgemäße thermoelektrische Umwandlungselemente auf einem Wafer aufzubringen. **Abbildung 6b** zeigt schematisch eine Anordnung mehrerer erfindungsgemäßer Umwandlungselemente, schematisch gezeigt in **Abbildung 6a,** in Form von Streifen auf einem Wafer-Boden. Die Elektroden zum Kontaktieren können streifenförmig vorder- und rückseitig aufgebracht sein. Die gestrichelten Linien in **Abbildung 6b** stellen die Schneidbahnen dar, längs derer der Wafer geschnitten werden kann. **Abbildung 7** zeigt ein erfindungsgemäßes TE -Element wie in **Abbildung 6a,** jedoch in der Seitenansicht mit p- und n-Struktur sowie beidseitig kontaktierenden Elektroden A und B.

Vorzugsweise sind, wie in den **Abbildungen 6b** und **7** gezeigt, Elektroden A und B auf den Seitenflächen der Schichtstruktur gebildet, so dass die p-Typ und n-Typ Substrate, die zueinander in der Richtung der Schichtung benachbart sind, elektrisch durch die Elektrode miteinander verbunden sind. Das Material, die Form und das Herstellverfahren zum Aufbringen von solchen Elektroden sind hierbei keinen fachuntypischen Einschränkungen unterworfen. Zum Beispiel kann Elektroplattieren, elektroloses Plattieren, oder eine Kombination von Elektroplattieren und elektrolosem Plattieren vorgenommen werden. Ferner können die Elektroden durch Sintern einer leitfähigen Paste gebildet werden. Ferner können die Materialien der Elektroden die Elemente Gold, Silber, Kupfer, Platin, Nickel, Kohlenstoff, oder eine Legierung elektrischer Leiter enthalten. Die Erfindung wird im Folgenden anhand von Beispielen näher erläutert.

**Beispiel 1: Herstellung eines TE.**

Jeweils p- und n-legiertes Siliziumpulver wurde in einer Heißsintervorrichtung zu einer p-n-Siliziumpulverschüttung mit einer Dichte von 0,4 g cm$^{-3}$, einem Durchmesser von 1 Inch und einer Dicke von 5 mm zubereitet. Das Pulverbett wurde in eine poröse Siliziumplatte umgewandelt. Die Synthese von mit 2 % Bor (p-Typ) bzw. 2% Antimon (n-Typ) legiertem Silizium wurde analog dem in der Offenlegungsschrift EP 3025700 A1 beschriebenen Verfahren durchgeführt. Bei der Silan-Boran-Zersetzung können Plasmapyrolyse, Hotwallreaktorpyrolyse, Laserpyrolyse, UV-Lichtpyrolyse angewandt werden. Insbesondere wurden der Silan- und der Legierungsanteil mit einem Molarverhältnis von Si-Legierung = 1:0,02 gewichtet. Danach wurde das Pulver in eine tiegelartige Form gestreut und in einem elektrischen Sparksinter-Ofen platziert und dann einer Strom-Wärmebehandlung bei etwa 900 °C unter Druck für etwa 0,5 Stunden unterzogen, um die thermoelektrische Siliziumplatte zu erhalten. Bei der Durchführung des Heißsinterns im Schritt 3 gewählte Temperaturen, Drücke und die Zeitdauern, während der das dotierte Material jeweils der Temperatur und dem Druck ausgesetzt war, zeigt **Tabelle 1.**

**Tabelle 1.**

| Material und Dotierung | Masse [g] | Temp-Fühler am | max. Druck [bar] | max. Temperatur [°C] | Dauer [s] |
|---|---|---|---|---|---|
| Si + Sb | 0,5 | Mantel | 156 | 800 | 60 |
| Si + Sb | 0,5 | Mantel | 34 | 850 | 60 |
| Si + Bor | 0,5 | Mantel | 156 | 900 | 60 |
| Si + Bor | 0,5 | Mantel | 156 | 950 | 180 |

(fortgesetzt)

| Material und Dotierung | Masse [g] | Temp-Fühler am | max. Druck [bar] | max. Temperatur [°C] | Dauer [s] |
|---|---|---|---|---|---|
| Si + Bor | 0,5 | Mantel | 156 | 950 | 120 |

Um bei der Herstellung des erfinderischen thermoelektrischen Generatorelements die Wärmeleitfähigkeit anzupassen, wurde beim Einsatz des Siliziumlegierungspulvers die Wärmeleitfähigkeit Y in mW m$^{-1}$ K$^{-1}$ als Funktion der mittleren Partikelgröße x in nm ermittelt. Im Rahmen der Erfindung wird der Begriff "mittlere Partikelgröße x" zum Begriff "Partikelgröße x" abgekürzt.
Im Bereich x von 10 nm und 1000 nm erhielt man mit Hilfe fachüblicher numerischer Methoden näherungsweise den Zusammenhang von Y mit x:

$$Y = Y(x) \approx 0{,}0313\,x^2 + 68{,}28\,x + 390{,}64,$$

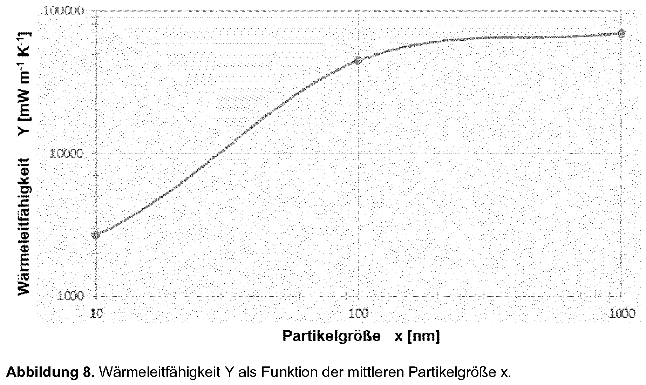

graphisch dargestellt in **Abbildung 8.**
Die Partikelgröße x, hier gleichbedeutend mit der Primärpartikelgröße, die bei der Ermittlung von Y(x) herangezogen wurde, ermittelte man durch Auswertung von Aufnahmen der Transmissionselektronenmikroskopie (TEM) unter Zuhilfenahme fachüblicher Auswertemethoden. In dem vorliegenden erfinderischen Beispiel wurde die **Abbildung 2a,** die eine TEM Aufnahme des erfindungsgemäß eingesetzten Siliziumpulvers vor der Durchführung des Schrittes 3 zeigt, für die Ermittlung des Wertes von x herangezogen. Man erhielt einen Wert in nm von x = 60.
Mit dem ermittelten Wert der Partikelgröße x dieses Pulvers erhielt man über das Diagramm in **Abbildung 8** die Wärmeleitfähigkeit. Dieses lieferte hierfür einen Wert für die Wärmeleitfähigkeit von etwa 4601 mW m$^{-1}$ K$^{-1}$, gleich dem Wert für Y der o.g. Näherungsformel, in welche man x = 60 einsetzt.
Das p- bzw. n-legierte Siliziumpulver mit der mittleren Partikelgröße in nm von x = 60 wurde gemäß Schritt 3 des erfindungsgemäßen Verfahrens gepresst und heißgesintert. Dadurch wurde eine physikalische Dichte Dg von 1,1 g cm$^{-3}$ erhalten. Die **Abbildung 2b** zeigt eine TEM Aufnahme des erfindungsgemäß eingesetzten Siliziumpulvers nach Durchführung des Schrittes 3, wobei eine Dichte von 1,1g cm$^{-3}$ erhalten worden ist.
Man kann aus der oben ermittelten, nach Schritt 3 vorliegenden physikalischen Dichte und dem auf erwähnte Weise errechneten Wert der Wärmeleitfähigkeit eine *"effektive Wärmeleitfähigkeit"* WLFeff errechnen, indem man die Wärmeleitfähigkeit mit dem Dichtefaktor Deff

$$Deff = \exp\{\,(Dg / 2{,}3) - 0{,}08\,\},$$

gewichtet, wobei Dg der Wert der gemessenen physikalischen Dichte in g cm$^{-3}$ ist:

$$WLFeff = Y * Deff.$$

Mit der besagten Dichte von 1,1g cm$^{-3}$, eingesetzt in den Ausdruck für Deff,

$$Deff = \exp\{\,(1{,}1/2{,}3) - 0{,}08\} = 1{,}489,$$

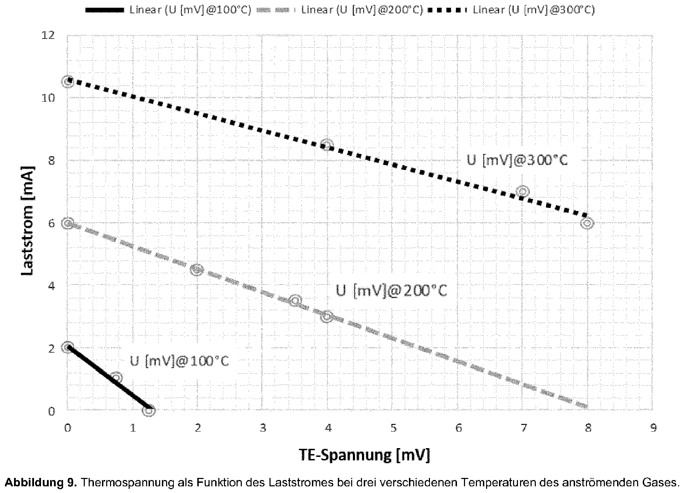

erhielt man einen Wert von WFLeff in mW m$^{-1}$ K$^{-1}$ von 4601 * 1,489 oder 6852.
Des Weiteren wurde der über das TE geführte Laststrom als Funktion der thermoelektrischen Spannung und der Temperatur des TE gemessen. Diese Daten sind in **Abbildung 9** graphisch dargestellt.

**Beispiel 2: Serienschaltung erfindungsgemäßer TE.**

Es wurden zwei erfindungsgemäße TE hergestellt, jedes davon wie im Beispiel 1, und zwar jeweils mit den Abmessungen 1 mm Dicke, 4 mm Tiefe und 10 mm Höhe. Diese TE wurden auf je eine Trägerplatte aus Keramik aufgebracht. In einem anderen Beispiel hat sich anstelle der Keramik auch Polyimid als geeignet erwiesen. Auf der der Trägerplatte gegenüberliegenden Seite wiesen beide TE jeweils eine Oxidschicht auf.
Die Kontaktierung der p-dotierten Seite eines TE mit der n-dotierten Seite des anderen TE für die Serienschaltung und nach außen wurde durch Kupferpads realisiert, so dass eine

Kupferpad - np - Kupferpad - np - Kupferpad

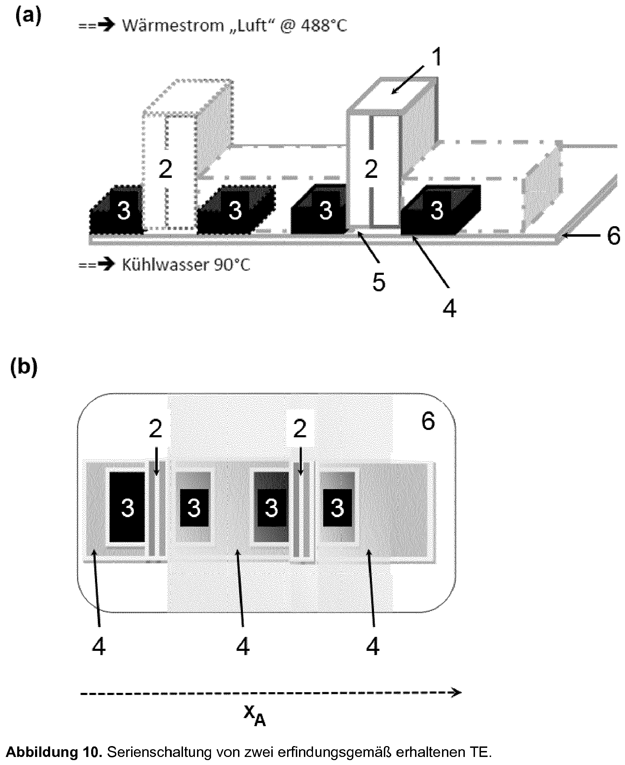

Serienschaltung der TE vorlag. Den Aufbau zeigt die **Abbildung 10** schematisch in perspektivischer Ansicht **(a)** und in Draufsicht **(b).**

Die Hinweiszeichen in **Abbildung 10** bedeuten:

1 Oxidschicht
2 TE mit links p-, rechts n-dotierter Seite
3 Kontaktplättchen
4 Kupferpad
5 Trägerplatte
6 Bodenplatte aus Stahl

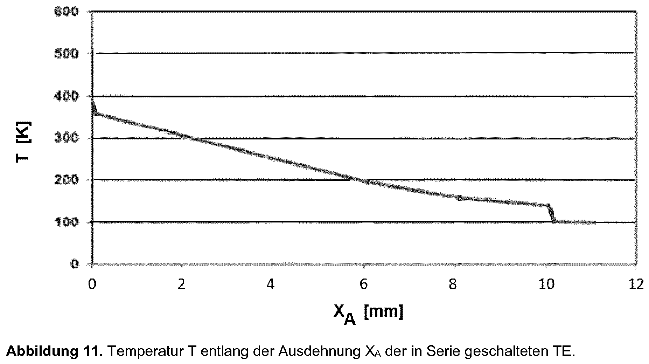

$X_A$ Längsrichtung, entlang der der Temperaturverlauf **(Abbildung 11)** gemessen wurde

Die TE standen mit ihren Trägerplatten auf einer Bodenplatte aus Stahl, die auf der anderen Seite mit Kühlmedium in Kontakt gebracht war. Jedes TE auf seiner Trägerplatte war zusätzlich mittels Kontaktplättchen gehaltert.

Der Wärmestrom, der durch Luft oder Abgas mit gegebener Temperatur bereit gestellt wurde, ging über das TE zum Kühlmedium.

Des Weiteren wies die Anordnung eine Isolierschüttung von 5 mm Höhe auf. Die Kontakte waren eingebettet.

Vorzugsweise konnte die Anordnung mit einem zusätzlichen Schutz der Kontakte versehen sein, der zugleich einen hohen Wärmewiderstand zur Kühlseite hin gewährleistete.

Als Isoliermaterial waren Aerogel, Aerosil, Glas und andere Materialien mit dem Fachmann bekanntem Funktionsumfang möglich.

Die Serienschaltung mit den erfindungsgemäßen oder erfindungsgemäß hergestellten TE wies eine effektive Fläche von 4,0 mm$^2$ auf. Es wurde ein Wärmefluss von 0,7 W über die TE gemessen. An den Klemmen konnte eine elektrische Leistung von 37 mW abgenommen werden, woraus sich ein thermoelektrischer Wirkungsgrad $\eta$ von etwa 5 % ergab.

Ausgehend von einem über die Serienschaltung geführten Wärmestrom, gleichbedeutend mit dem heißen Medium, beispielsweise erhitzte Luft oder Abgas, mit einer Temperatur von 488 °C und einer Temperatur vom 90 °C des Kühlwasserstromes, beide Ströme dargestellt in **Abbildung 10 (a),** wurde der in **Abbildung 11** graphisch dargestellte Temperaturverlauf längs der Richtung $X_A$ der Ströme gemessen.

Wurde die Temperatur des Wärmestromes geändert, ergaben sich andere Temperaturverläufe und Wärmeleitfähigkeitswerte. Die **Tabelle 2** zeigt den Vergleich dieser Werte bei einer Temperatur des Wärmestromes von 380 °C bzw. 488 °C. Anhand des Temperaturverlaufes abgeschätzte Wärmeleitfähigkeiten Y sind in der Tabelle mit * gekennzeichnet.

**Tabelle 2.** Wärmeleitfähigkeiten als Funktion des Temperaturverlaufes bei zwei Temperaturen des Wärmestromes.

| Schicht | Komposit | Dicke d [mm] | $x_A$[mm] | Y [mW/m*K] | Temp- Verlauf T [°C] | Dicke d [mm] | $X_A$[mm] | Temp- Verlauf T [°C] |
|---|---|---|---|---|---|---|---|---|
| | | Source | Luft | | 488°C | | Luft | 380°C |
| 1 | Silizium-oxid | 0,10 | 0,10 | 500,0* | 395,01 | 0,10 | 0,10 | 301,54 |
| 2 | Silizium n/p | 6,00 | 6,10 | 6.852,0 | 357,81 | 4,00 | 4,10 | 270,15 |
| 3 | Silizium Kontakt | 2,00 | 8,10 | 10.000,0* | 194,95 | 2,00 | 6,10 | 178,55 |
| 4 | Silizium Kontakt | 2,00 | 10,10 | 20.000,0* | 157,75 | 2,00 | 8,10 | 147,16 |
| 5 | Festkörperübergang-Boden | 0,10 | 10,20 | 500,0* | 139,15 | 0,10 | 8,20 | 131,47 |
| 6 | Stahl | 1,00 | 11,20 | 70.000,0* | 101,96 | 1,00 | 9,20 | 100,09 |
| effektive Fläche | 4,0 | [mm$^2$] | Wasser | | 90 | | Wasser | 90 |
| Wirkungsgrad | | % | | | 5 | | | 1,5 |
| Elektrischer Leistungsfluss | | mW | | | 36 | | | 9 |
| Wärmefluss | | [mW] | | | 700 | | | 600 |

**Patentansprüche**

1. Thermoelektrisches Umwandlungselement TE,
   **dadurch gekennzeichnet,**
   **dass** das Element zumindest zwei poröse Schichten aufweist, von denen zumindest eine Schicht n- und zumindest eine andere Schicht p- dotiertes Material enthält oder ist, wobei das Material der porösen Schichten heißgesintert ist.

2. TE nach Anspruch 1, wobei das Material der porösen Schichten n- bzw. p-dotiert ist.

3. TE nach Anspruch 1 oder 2, wobei das TE kann eine Vielzahl vom p-Typ und eine Vielzahl vom n-Typ Elemente aufweist, die alternierend aufeinander geschichtet sind.

4. TE nach einem der vorhergehenden Ansprüche, wobei zumindest eines der Materialien dotiertes Silizium ist.

5. TE nach einem der vorhergehenden Ansprüche, wobei das Basismaterial der n- und p-dotierten Schicht oder Schichten Silizium ist.

6. TE nach einem der vorhergehenden Ansprüche, das bei Einsatztemperaturen von 500 °C bis 700 °C einen thermoelektrischen Gütefaktor ZT von 1 innerhalb fachüblicher Meßfehlergrenzen aufweist, wobei ein Seebeck-Koeffizient von 100 bis 200 $\mu$V K$^{-1}$ vorliegt.

7. Verfahren zur Herstellung eines thermoelektrischen Umwandlungselementes TE nach zumindest einem der Ansprüche 1 - 6, das die Schritte aufweist

   1) Bereitstellen von p-Typ und n-Typ Pulver-Substraten,
   2) Aufschichten der p-Typ und n-Typ Pulver-Substrate, wobei eine Schichtung erhalten wird,
   3) Verdichten der Schichtung mittels Pressen und Heißsintern auf eine Dichte, wobei das thermoelektrische Umwandlungselement TE erhalten wird.

8. Verfahren nach Anspruch 7, wobei
   Siliziumpulver eingesetzt und im Schritt 3 auf eine Dichte von etwa 0,1 g cm$^{-3}$ bis zu 2,2 g cm$^{-3}$ verdichtet wird.

9. Verwendung des TE nach einem der Ansprüche 1 - 6 bei Temperaturen bis zu 1200 °C.

10. Verwendung nach Anspruch 9 bei metallurgischen Prozessen, in Abgasströmen bei Verbrennungsprozessen oder in Heizanlagen.

**Abbildung 1.** Schematische Darstellung des erfindungsgemäßen Schrittes 3.

**Abbildung 2a.** TEM Aufnahme des Siliziumpulvers.

**Abbildung 2b.** TEM Aufnahme des Siliziumpulvers nach Pressen und Heißsintern auf eine Dichte von 1,1 g cm$^{-3}$.

**Abbildung 3a.** Siliziumlegierungspulver, z.B. aus der Gas-Pyrolyse gewonnen.

**Abbildung 3b.** Siliziumlegierungspulver nach dem Verdichten auf mäßige Wärmeleitfähigkeit bei etwa 1,1 g cm$^{-3}$.

**Abbildung 3c.** Siliziumlegierungspulver nach dem Verdichten auf 90 % der theoretisch möglichen Festkörperdichte von etwa 2,15 g cm$^{-3}$, verbunden mit einer hohen Wärmeleitfähigkeit.

**Abbildung 4**. Wärmeleitmechanismen in porösen bzw. pulvrigen Medien (schematisch): Strahlung (1), Festkörperkontaktleitung (2), Gasleitung (3), Festkörper-Gas-Kopplung (4).

**Abbildung 5**. p-Typ und n-Typ enthaltendes Umwandlungselement nach erfindungsgemäßem Pressen und Heißsintern.

**Abbildung 6a.** Einzelnes TE-Element.

**Abbildung 6b.** Wafer-Boden aufweisend p- und n-Strukturen.

**Abbildung 7.** TE-Element wie in **Abbildung 6a**, jedoch in der Seitenansicht mit p- und n-Struktur sowie beidseitig kontaktierenden Elektroden.

**Abbildung 8.** Wärmeleitfähigkeit Y als Funktion der mittleren Partikelgröße x.

**Abbildung 9.** Thermospannung als Funktion des Laststromes bei drei verschiedenen Temperaturen des anströmenden Gases.

(a)

==➤ Wärmestrom „Luft" @ 488°C

==➤ Kühlwasser 90°C

(b)

$x_A$

**Abbildung 10.** Serienschaltung von zwei erfindungsgemäß erhaltenen TE.

**Abbildung 11.** Temperatur T entlang der Ausdehnung $X_A$ der in Serie geschalteten TE.

**Europäisches Patentamt**
**European Patent Office**
**Office européen des brevets**

# EUROPÄISCHER RECHERCHENBERICHT

**Nummer der Anmeldung**

EP 19 15 2254

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | DE 10 2007 039060 A1 (EVONIK DEGUSSA GMBH [DE]) 19. Februar 2009 (2009-02-19) | 1-5,9,10 | INV. H01L35/22 H01L35/34 |
| A | * Absatz [0064] - Absatz [0085] * * Absatz [0088]; Abbildung 4 * | 6-8 | |
| X | EP 3 273 494 A1 (HAKUSAN INC [JP]) 24. Januar 2018 (2018-01-24) | 1-6,9,10 | |
| A | * Absatz [0027] - Absatz [0074]; Abbildungen 1-18 * | 7,8 | |
| X | US 2014/230870 A1 (KONDO JUNGO [JP]) 21. August 2014 (2014-08-21) | 1-3,6,7,9,10 | |
| A | * Absatz [0033] - Absatz [0046]; Abbildung 1 * | 4,5 | |
| A | US 2013/307200 A1 (CARBERRY JOHN [US] ET AL) 21. November 2013 (2013-11-21) * Absatz [0019] - Absatz [0039]; Abbildungen 1-3 * | 1-10 | |
| A | US 2007/240749 A1 (OHTAKI MICHITAKA [JP]) 18. Oktober 2007 (2007-10-18) * Absatz [0028] - Absatz [0051] * | 1-10 | RECHERCHIERTE SACHGEBIETE (IPC)  H01L |

Der vorliegende Recherchenbericht wurde für alle Patentansprüche erstellt

| Recherchenort | Abschlußdatum der Recherche | Prüfer |
|---|---|---|
| Den Haag | 18. Juni 2019 | Kirkwood, Jonathan |

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**

EP 19 15 2254

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

18-06-2019

| Im Recherchenbericht angeführtes Patentdokument | Datum der Veröffentlichung | Mitglied(er) der Patentfamilie | Datum der Veröffentlichung |
|---|---|---|---|
| DE 102007039060 A1 | 19-02-2009 | DE 102007039060 A1<br>WO 2009024414 A2 | 19-02-2009<br>26-02-2009 |
| EP 3273494 A1 | 24-01-2018 | EP 3273494 A1<br>US 2018083177 A1<br>WO 2016147301 A1 | 24-01-2018<br>22-03-2018<br>22-09-2016 |
| US 2014230870 A1 | 21-08-2014 | DE 102014203052 A1<br>JP 2014165188 A<br>US 2014230870 A1 | 21-08-2014<br>08-09-2014<br>21-08-2014 |
| US 2013307200 A1 | 21-11-2013 | KEINE | |
| US 2007240749 A1 | 18-10-2007 | JP 4839430 B2<br>JP WO2005091393 A1<br>US 2007240749 A1<br>WO 2005091393 A1 | 21-12-2011<br>22-05-2008<br>18-10-2007<br>29-09-2005 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 3025700 A1

**In der Beschreibung aufgeführte Nicht-Patentliteratur**

- *Showa-Densen-Review,* 2008, vol. 58 (1